# EUROPÄISCHE PATENTSCHRIFT

(11) **EP 1 890 338 B1**
(45) Veröffentlichungstag und Bekanntmachung des Hinweises auf die Patenterteilung: **22.06.2011**
(21) Anmeldenummer: 06017318.4
(22) Anmeldetag: 19.08.2006
(51) Int. Cl.: H01L 31/18, H01L 31/0236, H01L 21/306

(54) **Verfahren zum Texturieren von Siliziumwafern zur Herstellung von Solarzellen**
Method of texturing silicon wafer for fabricating solar cells
Méthode de texturisation de plaquette de silcium pour la fabrication de cellules solaires

(43) Veröffentlichungstag der Anmeldung: 20.02.2008
(73) Patentinhaber: Universität Konstanz, 78464 Konstanz (DE)
(72) Erfinder: Fath, Peter, 78464 Konstanz (DE); Melnyk, Ihor, 78465 Konstanz (DE); Wefringhaus, Eckard, 88709 Meersburg (DE)
(74) Vertreter: RACKETTE Partnerschaft Patentanwälte

(56) Entgegenhaltungen:
- US-A- 4 918 030
- US-A1- 2004 112 426
- VAZSONYI E ET AL: "Improved anisotropic etching process for industrial texturing of silicon solar cells - An Introduction to Design, Data Analysis and Model Building" SOLAR ENERGY MATERIALS AND SOLAR CELLS, ELSEVIER SCIENCE PUBLISHERS, AMSTERDAM, NL, Bd. 57, Nr. 2, 26. Februar 1999 (1999-02-26), Seiten 179-188, XP004157015 ISSN: 0927-0248

## Beschreibung

Die Erfindung betrifft ein Verfahren zum Texturieren von Siliziumwafern zur Herstellung von Solarzellen.

Ein Verfahren zum Texturieren von Siliziumwafern zur Herstellung von Solarzellen ist beispielsweise aus DE 698 11 511 T2 bekannt. Bei dem vorbekannten Verfahren wird der Siliziumwafer in eine Texturierlösung eingebracht, die Wasser, eine alkalische Lösung aus 0,01 bis 8 Gewichtsprozent NaOH oder 3 Gewichtsprozent bis 6 Gewichtsprozent KOH sowie ein grenzflächenaktives Mittel (Sintrex von Nippon Oil and Fat Company, Ltd.) enthält, das vorzugsweise mit mehr als 1 Gewichtsprozent zugesetzt ist. Das grenzflächenaktive Mittel lässt sich durch einen Isopropylalkohol ersetzen, wobei hier die Texturierung typischerweise bei einer Temperatur von etwa 85 Grad Celsius erfolgt.

Ein Verfahren zum Texturieren von Siliziumwafern ist auch aus "Improved anisotropic etching process for industrial texturing of silicon solar cells" (Solar Energy Materials of Solar Cells 57, 179-188/ Von Vazsonyi et al. bekannt.

Der Erfindung liegt die Aufgabe zugrunde, ein Verfahren zum Texturieren von Siliziumwafern zur Herstellung von Solarzellen anzugeben, das verhältnismäßig wirtschaftlich ist.

Diese Aufgabe wird bei einem Verfahren zum Texturieren von Siliziumwafern zur Herstellung von Solarzellen dadurch gelöst, dass bei dem Schritt des Einbringens eines Siliziumwafers in einer Texturierlösung die Texturierlösung eine Temperatur von wenigstens 80 Grad Celsius aufweist und aus Wasser versetzt mit 1 Gewichtsprozent bis 6 Gewichtsprozent KOH oder 2 Gewichtsprozent bis 8 Gewichtsprozent NaOH sowie mit einem Tensid oder einem Tensidgemisch mit weniger als 0,01 Gewichtsprozent besteht.

Ansonsten ist die Texturierlösung frei von weiteren Bestandteilen oder Zusätzen.

Gemäß der Erfindung ist die Konzentration an Tensiden beziehungsweise Tensidgemischen in der Texturierlösung äußerst gering, so dass unerwünschte Eigenschaften bei der verhältnismäßig hohen Prozesstemperatur, beispielsweise Schaumbildung, nicht zum Tragen kommen und dennoch eine relativ hohe Ätzrate erzielt wird, die ein wirtschaftliches Texturieren erlaubt.

Bei einem erfindungsgemäßen Ausführungsbeispiel ist zweckmäßig, dass die Texturierlösung ein Tensid oder ein Tensidgemisch mit weniger als 0,005 Gewichtsprozent aufweist.

Bei einem weiteren erfindungsgemäßen Ausführungsbeispiel beträgt die Konzentration an Tensid oder Tensidgemisch sogar weniger als 0,001 Gewichtsprozent.

Vorteilhafte Konzentrationen von KOH liegen bei 3 Gewichtsprozent bis 5 Gewichtsprozent, von NaOH bei 4 Gewichtsprozent bis 6 Gewichtsprozent.

Die Temperatur der Texturierlösung liegt bei vorteilhaften Ausführung bei wenigstens 90 Grad Celsius, vorzugsweise bei 95 Grad Celsius und besonders bevorzugt bei wenigstens 97 Grad Celsius.

Die Erfindung wird nachfolgend anhand von Ausführungsbeispielen näher erläutert.

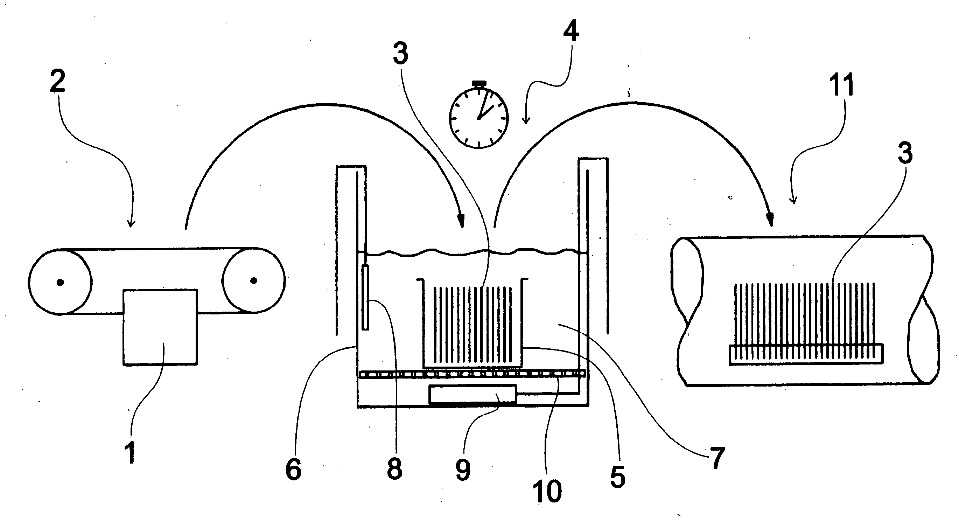

In der einzigen Figur der Zeichnung ist der typische Aufbau einer Anordnung dargestellt, mit der unter Einschluss des erfindungsgemäßen Verfahrens Siliziumwafer im Rahmen der Ausführungsbeispiele bearbeitet worden sind.

Ein Siliziumwürfel 1, ein sogenannter "Ingot" wurde an einer Sägestation 2 in einzelne Siliziumwafer 3 gesägt. Die Siliziumwafer 3 befinden sich beim Durchführen des erfindungsgemäßen Verfahrens in einer Texturierstation 4 als Stapel in einem Waferhalter 5, der in einem Texturierlösungsbehälter 6 angeordnet ist. Der Texturierlösungsbehälter 6 ist mit einer Texturierlösung 7 so ausreichend gefüllt, dass die Siliziumwafer 3 vollständig in der Texturierlösung 7 eingetaucht sind. Die Temperatur der Texturierlösung 7 wird mit einem mit der Texturierlösung 7 im thermischen Kontakt stehenden Temperatursensor 8 gemessen, während die Temperatur über ein ebenfalls in die Texturierlösung 7 eingetauchtes Heizelement 9 beeinflusst wird. Zwischen dem Heizelement 9 und dem Waferhalter 5 ist eine Lochplatte 10 angeordnet. Nach Durchführen des erfindungsgemäßen Verfahrens in dieser Texturierstation 4 werden die Siliziumwafer 3 in eine Diffusionsstation 11 verbracht, in der sie zum Herstellen von Solarzellen weiterverarbeitet werden.

Bei allen nachfolgenden Ausführungsbeispielen wurde als alkalische Lösung KOH, Semiconductor Grade Puranal ® (Honeywell 17851) verwendet.

Sämtliche Ausführungsbeispiele verwenden monokristalline Siliziumwafer ( (100)-Cz, as-cut, p-Typ (Bor), 125 mm x 125 mm, 150 mm Durchmesser, Dicke 300 µm) der Hersteller M. Setek (0,8 - 2,0 Ohm.cm) oder Deutsche Solar (0,5 - 1,7 Ohm.cm). Die Siliziumwafer würden wie gesägt verwendet. Die Sägeschäden wurden nicht entfernt. Es versteht sich jedoch, dass die Siliziumwafer vor Durchführen des erfindungsgemäßen Verfahrens zum Entfernen der Sägeschäden auch geätzt oder einer Isotexturbehandlung unterzogen worden sein können.

Die Werte für die Reflexion als Kennwert für die photovoltaische Umwandlungseffizienz schwanken typischerweise um etwa 1 % absolut.

### Geschirrspülmittel-Konzentrat "Reiny"

Bei diesem Ausführungsbeispiel wird ein im Haushalt verwendetes Geschirrspülmittel-Konzentrat (Handelsmarke "Reiny") mit weniger als 5 Gewichtsprozent nichtionischen Tensiden, amphoteren Tensiden und mehr als 30 Gewichtsprozent anionischen Tensiden verwendet.

Die weiteren Parameter sowie die Ergebnisse bei einer beispielhaften Durchführung eines erfindungsgemäßen Verfahrens finden sich in nachfolgender Tabelle.

**Tabelle 1**

| (Geschirrspülmittel-Konzentrat "Reiny") | | | | |
|---|---|---|---|---|
| Tensid Gew % | KOH Gew % | Temperatur Grad Celsius | Zeit min | Reflexion % |
| ohne | 2 | ≈ 98 | 10 | 16,6 |
| 0,001 | 3 | ≈ 98 | 10 | 11,4 |

Aus Tabelle 1 lässt sich entnehmen, dass bei dem Vergleichsversuch ohne Tensid die Reflexion um 50 % höher liegt als bei Einsatz des Geschirrspülmittel-Konzentrats mit einer Konzentration von 0,001 Gewichtsprozent. Demnach lässt bereits diese sehr geringe Konzentration an einem Tensid beziehungsweise an einem Tensidgemisch einen wesentlichen Effekt hinsichtlich einer Verbesserung der fotovoltaischen Umwandlungseffizienz erwarten. Dazu wird ein Reflexionswert von weniger als 13 %, vorzugsweise von deutlich weniger als 12, 5 % angestrebt.

### Reiniger "M14"

Bei diesem Ausführungsbeispiel wurde als Tensidgemisch ein kommerziell verfügbarer Reiniger mit der Bezeichnung "M14" des Herstellers Martin & Co., Freiburg, Deutschland verwendet, der aus im Wesentlichen 5 Gewichtsprozent bis 15 Gewichtsprozent anionischen Tensiden, nichtionischen Tensiden, Konservierungsmittel und Amiden besteht.

Typische Parameter und das Texturierungsergebnis sind in der nachfolgenden Tabelle zusammengefasst.

**Tabelle 2**

| (Reiniger "M14") | | | | |
|---|---|---|---|---|
| Tensid Gew % | KOH Gew % | Temperatur Grad Celsius | Zeit min | Reflexion % |
| Referenz "as-cut" | | | | 27,0 |
| ohne | 4 | 80 | 10 | 31,2 |
| 0,00075 | 3 | ≈ 98 | 25 | 12,7 |
| 0,001 | 4 | ≈ 98 | 10 | 11,1 |
| 0,0015 | 4 | ≈ 98 | 15 | 12,7 |
| 0,0022 | 4 | ≈ 98 | 15 | 12,9 |
| 0,003 | 4 | ≈ 98 | 10 | 13,7 |
| 0,0032 | 5 | ≈ 98 | 10 | 11,1 |
| 0,0045 | 5 | ≈ 98 | 15 | 12,3 |

Auch hier ergeben sich in der Regel bei dem erfindungsgemäßen Verfahren akzeptable Werte für die Reflexion. Deutlich erkennbar ist die Verbesserung der Reflexion gegenüber dem unbehandelten Siliziumwafer nach dem Sägen (Referenz "as-cut") sowie der Ätzung ohne Tensid.

### ALO

Bei diesem Ausführungsbeispiel wurde als Tensid beziehungsweise als Tensidgemisch Ammonyx LO (Lauryl-Myristyl Dimethylaminoxid in wässriger Lösung, 30,1 % Dodecyldimethylaminoxid), kationisch, Goldschmidt AG Essen, Batch PA127A0077, verwendet.

**Tabelle 3**

| ("ALO") | | | | |
|---|---|---|---|---|
| Tensid Gew % | KOH Gew % | Temperatur Grad Celsius | Zeit min | Reflexion % |
| 0,002 | 4 | 97-98 | 10 | 13,3 |
| 0,0035 | 4 | 97-98 | 20 | 12,2 |
| 0,005 | 4 | 97-98 | 30 | 11,6 |

### TEC

Bei diesem Ausführungsbeispiel wurde als Tensid beziehungsweise als Tensidgemisch Tegotens EC 11 (endgruppenverschlossenes Fettalkoholethoxylat), nichtionisch, Goldschmidt AG Essen, Batch ES993200616, verwendet.

**Tabelle 4**

| ("TEC") | | | | |
|---|---|---|---|---|
| Tensid Gew % | KOH Gew % | Temperatur Grad Celsius | Zeit min | Reflexion % |
| 0,00015 | 3 | 97-98 | 10 | 17,1 |
| 0,00015 | 3 | 97-98 | 15 | 13,6 |
| 0,00015 | 3 | 97-98 | 20 | 12,6 |
| 0,00015 | 3 | 97-98 | 20 | 12,7 |
| 0,00015 | 3 | 97-98 | 20 | 13,0 |
| 0,00015 | 3 | 97-98 | 30 | 11,8 |
| 0,00015 | 3 | 97-98 | 30 | 12,3 |
| 0,00015 | 3 | 97-98 | 30 | 13,3 |
| 0,0002 | 3 | 97-98 | 20 | 12,3 |
| 0,0003 | 4 | 97-98 | 30 | 11,9 |
| 0,0004 | 4 | 97-98 | 30 | 12,6 |
| 0,0005 | 5 | 97-98 | 20 | 12,7 |
| 0,0005 | 5 | 97-98 | 30 | 13,1 |
| 0,0006 | 5 | 97-98 | 20 | 12,7 |
| 0,0006 | 5 | 97-98 | 30 | 13,3 |
| 0,0006 | 6 | 97-98 | 20 | 12,3 |

Aus Tabelle 4 lässt sich entnehmen, dass ab einer bestimmten Zeit sich bei zunehmenden Zeiten für das Texturieren der Reflexionswert nicht mehr wesentlich ändert. Erkennbar sind hier auch die Schwankungen in der Reflexion bei gleichen Versuchsbedingungen.

Darüber hinaus läßt sich Tabelle 4 entnehmen, dass selbst bei Konzentrationen an Tensiden beziehungsweise Tensidgemischen von weniger als 0,001 Gewichtsprozent bereits zufriedenstellende Reflexionswerte erzielt werden.

### REWO

Bei diesem Ausführungsbeispiel wurde als Tensid beziehungsweise als Tensidgemisch Rewoteric AM 2 C NM (40%ige, wässrige Lösung von N-Cocosfettsäure-amidoethyl-N-(2-hydroxiethyl)glycinat, Natriumsalz), amphoter, Goldschmidt AG Essen, Batch ST04219293, verwendet.

**Tabelle 5**

| ("REWO") | | | | |
|---|---|---|---|---|
| Tensid Gew % | KOH Gew % | Temperatur Grad Celsius | Zeit min | Reflexion % |
| 0,0002 | 2 | 97-98 | 20 | 12,3 |
| 0,0005 | 2 | 97-98 | 20 | 12,4 |
| 0,0010 | 2 | 97-98 | 20 | 12,4 |
| 0,0015 | 2 | 97-98 | 20 | 11,9 |
| 0,0020 | 3 | 97-98 | 20 | 12,4 |

### TDO

Bei diesem Ausführungsbeispiel wurde als Tensid beziehungsweise als Tensidgemisch Tegotens DO (wässrige Lösung eines Alkyldimethylaminoxid, 29,9 % Decyldimethylaminoxid), kationisch, Goldschmidt AG Essen, Batch PA03500400, verwendet.

**Tabelle 6**

| ("TDO") | | | | |
|---|---|---|---|---|
| Tensid Gew % | KOH Gew % | Temperatur Grad Celsius | Zeit min | Reflexion % |
| 0,003 | 3 | 97-98 | 15 | 12,6 |
| 0,003 | 3 | 97-98 | 20 | 12,5 |
| 0,004 | 3 | 97-98 | 10 | 12,9 |
| 0,004 | 3 | 97-98 | 15 | 12,4 |
| 0,004 | 3 | 97-98 | 20 | 12,4 |
| 0,005 | 3 | 97-98 | 1 | 28,2 |
| 0,005 | 3 | 97-98 | 2 | 23,9 |
| 0,005 | 3 | 97-98 | 3 | 17,7 |
| 0,005 | 3 | 97-98 | 4 | 16,5 |
| 0,005 | 3 | 97-98 | 6 | 13,1 |
| 0,005 | 3 | 97-98 | 8 | 13,2 |
| 0,005 | 3 | 97-98 | 10 | 12,4 |
| 0,005 | 3 | 97-98 | 20 | 12,0 |

Aus Tabelle 6 lässt sich bei der Konzentration von 0,005 Gewichtsprozent besonders deutlich die Abnahme der Reflexion innerhalb weniger Minuten erkennen, die nach einer Texturierzeit von 10 Minuten bereits akzeptable Werte erreicht.

### TDO Vergleichsversuch

Für einen Vergleichsversuch mit Annäherung an Tensidkonzentrationen an die untersten, als nicht mehr zweckmäßig gekennzeichneten Werte gemäß DE 698 11 511 T2 wurde das Tensidgemisch "TDO" gemäß vorgenannter Spezifikation verwendet.

Wesentliche Ergebnisse sind in nachfolgender Tabelle zusammengefasst.

**Tabelle 7**

| ("TDO Vergleichsversuch") | | | | |
|---|---|---|---|---|
| Tensid Gew % | KOH Gew % | Temperatur Grad Celsius | Zeit min | Reflexion % |
| 0,005 | 3 | 84-86 | 10 | 12,2 |
| 0,05 | 3 | 84-86 | 10 | 21,4 |
| 0,5 | 3 | 84-86 | 10 | 26,6 |

Aus Tabelle 7 lässt sich entnehmen, dass bei zunehmender Tensidkonzentration bis auf 0,5 Gewichtsprozent die Reflexion auf nicht akzeptable Werte ansteigt. Erhöht man die Temperatur, ergibt sich bei den hohen Konzentrationen eine äußerst nachteilige Schaumbildung, die prozesstechnisch kaum zu beherrschen ist.

Der erfindungsgemäße Effekt tritt erst bei einer Tensidkonzentration ein, der um etwa den Faktor 1000 niedriger ist als bei den bevorzugten Tensidkonzentrationsbereichen gemäß DE 698 11 511 T2.

## Patentansprüche

1. Verfahren zum Texturieren von Siliziumwafern zur Herstellung von Solarzellen mit dem Schritt des Einbringens eines Siliziumwafers in eine Texturierlösung, die eine Temperatur von wenigstens 80 Grad Celsius aufweist und die aus Wasser versetzt mit 1 Gewichtprozent bis 6 Gewichtprozent KOH oder 2 Gewichtprozent bis 8 Gewichtprozent NaOH sowie mit einem Tensid oder einem Tensidgemisch mit weniger als 0,01 Gewichtsprozent besteht.

2. Verfahren nach Anspruch 1, **dadurch gekennzeichnet, dass** die Texturierlösung ein Tensid oder ein Tensidgemisch mit weniger als 0,005 Gewichtsprozent aufweist.

3. Verfahren nach Anspruch 1, **dadurch gekennzeichnet, dass** die Texturierlösung ein Tensid oder ein Tensidgemisch mit weniger als 0,001 Gewichtsprozent aufweist.

4. Verfahren nach einem der Ansprüche 1 bis 3, **dadurch gekennzeichnet, dass** die Texturierlösung 3 Gewichtsprozent bis 5 Gewichtsprozent KOH aufweist.

5. Verfahren nach einem der Ansprüche 1 bis 3, **dadurch gekennzeichnet, dass** die Texturierlösung 4 Gewichtsprozent bis 6 Gewichtsprozent NaOH aufweist.

6. Verfahren nach einem der Ansprüche 1 bis 5, **dadurch gekennzeichnet, dass** die Temperatur wenigstens 90 Grad Celsius beträgt.

7. Verfahren nach einem der Ansprüche 1 bis 5, **dadurch gekennzeichnet, dass** die Temperatur wenigstens 95 Grad Celsius beträgt.

8. Verfahren nach einem der Ansprüche 1 bis 5, **dadurch gekennzeichnet, dass** die Temperatur wenigstens 97 Grad Celsius beträgt.

## Claims

1. Method of texturing silicon wafers for producing solar cells, having the step of introducing a silicon wafer into a texturing solution which is at a temperature of at least 80° Celsius and which comprises water mixed with 1% by weight to 6% by weight of KOH or 2% by weight to 8% by weight of NaOH and with less than 0.01% by weight of a surfactant or a mixture of surfactants.

2. Method according to claim 1, **characterised in that** the texturing solution has less than 0.005% by weight of a surfactant or a mixture of surfactants.

3. Method according to claim 1, **characterised in that** the texturing solution has less than 0.001% by weight of a surfactant or a mixture of surfactants.

4. Method according to one of claims 1 to 3, **characterised in that** the texturing solution has 3% by weight to 5% by weight of KOH.

5. Method according to one of claims 1 to 3, **characterised in that** the texturing solution has 4% by weight to 6% by weight of NaOH.

6. Method according to one of claims 1 to 5, **characterised in that** the temperature is at least 90° Celsius.

7. Method according to one of claims 1 to 5, **characterised in that** the temperature is at least 95° Celsius.

8. Method according to one of claims 1 to 5, **characterised in that** the temperature is at least 97° Celsius.

## Revendications

1. Procédé de texturation de plaquettes de silicium pour la réalisation de cellules solaires, comportant l'étape consistant à introduire une plaquette de silicium dans une solution de texturation, qui présente une température de 80 degrés Celsius au moins et qui est formée d'eau mélangée avec 1 % en poids à 6 % en poids de KOH ou 2 % en poids à 8 % en poids de NaOH, ainsi qu'avec un agent tensioactif ou un mélange d'agents tensioactifs avec moins de 0,01 % en poids.

2. Procédé selon la revendication 1, **caractérisé en ce que** la solution de texturation contient un agent tensioactif ou un mélange d'agents tensioactifs avec moins de 0,005 % en poids.

3. Procédé selon la revendication 1, **caractérisé en ce que** la solution de texturation contient un agent tensioactif ou un mélange d'agents tensioactifs avec moins de 0,001 % en poids.

4. Procédé selon l'une quelconque des revendications 1 à 3, **caractérisé en ce que** la solution de texturation contient 3 % en poids à 5 % en poids de KOH.

5. Procédé selon l'une quelconque des revendications 1 à 3, **caractérisé en ce que** la solution de texturation contient 4 % en poids à 6 % en poids de NaOH.

6. Procédé selon l'une quelconque des revendications 1 à 5, **caractérisé en ce que** la température est égale à au moins 90 degrés Celsius.

7. Procédé selon l'une quelconque des revendications 1 à 5, **caractérisé en ce que** la température est égale à au moins 95 degrés Celsius.

8. Procédé selon l'une quelconque des revendications 1 à 5, **caractérisé en ce que** la température est égale à au moins 97 degrés Celsius.
